# EUROPÄISCHE PATENTSCHRIFT

(11) **EP 3 066 684 B1**
(45) Veröffentlichungstag und Bekanntmachung des Hinweises auf die Patenterteilung: **10.04.2019**
(21) Anmeldenummer: 14784224.9
(22) Anmeldetag: 14.10.2014
(51) Int. Cl.: H01L 23/31, H01L 23/373, H01L 23/433, H01L 23/367, H01L 23/473, H01L 23/29

(54) **LEISTUNGSHALBLEITERMODUL MIT EINER EINEN HALBLEITERBAUSTEIN BEDECKENDEN UMHÜLLUNGSMASSE AUS ZEMENT**
POWER SEMICONDUCTOR MODULE WITH AN ENCAPSULANT OF CEMENT THAT COVERS A SEMICONDUCTOR COMPONENT
MODULE À SEMI-CONDUCTEUR DE PUISSANCE COMPORTANT UNE MATIÈRE D'ENROBAGE EN CIMENT RECOUVRANT UN COMPOSANT À SEMI-CONDUCTEUR

(30) Priorität: 07.11.2013 DE 102013112267
(43) Veröffentlichungstag der Anmeldung: 14.09.2016
(73) Patentinhaber: Heraeus Deutschland GmbH & Co. KG, 63450 Hanau (DE)
(72) Erfinder: EISELE, Ronald, 24229 Surendorf (DE)
(74) Vertreter: Heraeus IP
(86) Internationale Anmeldenummer: PCT/EP2014/072012
(87) Internationale Veröffentlichungsnummer: WO 2015/067441

(56) Entgegenhaltungen:
- DE-A1- 1 514 413
- DE-A1-102008 007 021
- DE-A1-102013 102 058
- JP-A- S60 226 149
- JP-A- 2010 245 566
- US-A1- 2009 047 797
- US-A1- 2010 090 335
- US-A1- 2011 124 483
- US-B2- 7 034 660

## Beschreibung

Die Erfindung betrifft ein Halbleitermodul mit einer einen Halbleiter bedeckenden Umhüllungsmasse.

US 7,034,660 B2 offenbart einen drahtlos arbeitenden Sensor, der in Beton oder einem anderen zementhaltigen Material eingebettet ist, um Parameter zu erfassen, die auf Veränderungen in der Bausubstanz hindeuten. Beispielsweise kann es sich bei dem Sensor um einen zur Erfassung von Chloridionen geeigneten elektrochemischen Sensor handeln.

Das Umhüllen von Einzel-Halbleitern und Halbleiter-Baugruppen (inkl. passiver Bauelemente) auf Substrate geschieht heute vorzugsweise durch organische Massen auf Epoxydharzbasis mit z.T. anorganischen Füllstoffen, wie Siliziumdioxid (SiO₂). Beispielsweise offenbart US 4,529,755 eine derartige Umhüllungsmasse umfassend eine polyfunktionelle Epoxidverbindung, ein Styrolblockcopolymer, einen Härter für die Epoxidverbindung und einen anorganischen Füllstoff.

Aus DE-A-1514413 ist ein Halbleitermodul bekannt, mit einer einen Halbleiterbaustein (Transistor) bedeckenden Umhüllungsmasse, wobei die Umhüllungsmasse Zement ist. Als geeignete Materialien werden z.B. Gemische aus Magnesiumoxid und Magnesiumchlorid oder aus Zinkoxid und Zinkchlorid erwähnt.

Diese umhüllten Bauelemente und Baugruppen haben typischerweise elektrische Anschlüsse und Kühlanschlussflächen für die eingebauten Leistungsbauelemente. Gehärtete Epoxydharze (unverstärkt) weisen typische thermische Dehnungskoeffizienten (CTE, coefficient of thermal expansion) von ca. 60-80 ppm/K auf. Substrate (Keramik-, Metall- und Organikkernleiterplatten) besitzen deutlich geringere thermische Ausdehnungskoeffizienten (3-20 ppm/K). Für leistungselektronische Anwendungen stehen Bauelemente und Baugruppen mit hohen Verlustleistungen und zum Teil auch hohen Betriebsspannungen, also Isolationsanforderungen im Mittelpunkt. In leistungselektronischen Bauelementen und Baugruppen werden überwiegend keramische Substrate mit Kernen aus Al₂O₃, AIN oder Si₃N₄ mit CTEs von 3-8 ppm/K eingesetzt.

Dabei werden diese Baugruppen weiter von organischen Massen umhüllt, die die resultierende Fehlanpassung zum keramischen Substrat durch elastische Dehnung und Modulverformung ausgleichen müssen. Diese Fehlanpassung zwischen keramischem Substrat und Umhüllungsmasse führt aber über den mechanischen Scherstress zu Delaminationen und Zerstörung der inneren Kontaktierung z.B. Bonddrähten.

Die Anreicherung des organischen Matrixmaterials durch Füllstoffe mit niedriger Dehnung führt zu niedrigen Viskositäten und kritischem Verhalten während der Verarbeitung. Die Massen werden bei hohen Temperaturen verflüssigt und unter hohem Druck in die Kavitäten der Werkzeugschalen gepresst, um eine lunkerfreie Füllung zu gewährleisten. Dieser Prozess ist allerdings mit steigendem Füllgrad fehlerbehaftet (Lunker) und wegen der hohen Temperaturen (160 °C - 200 °C) und Drücken (15-25 MPa) sehr energieaufwändig.

Schließlich führt die Notwendigkeit einer organischen Matrix zu einer sehr geringen Wärmeleitfähigkeit, die trotz der Füllstoffbeimengungen in der Regel nur unwesentlich über der Wärmeleitfähigkeit von Epoxydharzen liegt (ca. 0,4 W/mK).

Aufgabe der vorliegenden Erfindung ist es daher, ein als leistungselektronische Baugruppe ausgebildetes Halbleitermodul zu schaffen, das gegenüber thermischem Stress beständig ist.

Diese Aufgabe wird durch das Halbleitermodul mit den Merkmalen von Anspruch 1 gelöst. Der Unteranspruch gibt eine vorteilhafte Ausgestaltung der Erfindung wieder.

Grundgedanke der Erfindung ist es, Zement als rein anorganisches, metallfreies Material für die Umhüllung von Halbleiterbausteinen einzusetzen. Dabei steht im Vordergrund, dass eine angepasste thermische Dehnung zwischen einem Halbleiter (CTE typ. 2,5 - 4 ppm/K) und dem Umhüllungsmaterial entsteht.

Zemente sind oxydische Materialien und besitzen als anorganische und nichtmetallische Baustoffe eine Eigenschaftskombination, die für den Einsatz zur Umhüllung von Halbleitern vorteilhaft sind, nämlich eine hohe elektrische Isolation (20-100 kV/mm), eine relativ gute Wärmeleitfähigkeit (1-2 W/mK) und eine niedrige thermische Dehnung (2-10 ppm/K). Zemente werden üblicherweise aus den natürlichen Rohstoffen Kalkstein, Ton und Mergel gewonnen und können als Beimengungen Quarzsand und eisenoxidhaltige Stoffe für eine bessere Sinterung aufweisen. Beispielsweise kann ein für die vorliegende Erfindung besonders bevorzugt verwendeter Zement vorteilhafterweise aus den Basisrohstoffen Magnesiumoxid, Zirkonsilikat und Magnesiumphosphat hergestellt sein.

Zur Steigerung der Wärmeleitfähigkeit besitzt die anorganische, umhüllende Masse des Leistungsbauelementes bevorzugt als Zuschlagstoff Aluminiumnitrid und/oder Bornitrid. Günstig auf die Wärmeleitung wirken sich (gegebenenfalls in Kombination mit den vorgenannten Stoffen) auch die Zuschlagstoffe Aluminiumoxid und/oder Siliziumnitrid aus.

Bevorzugt stellt die Umhüllungsmasse eine Wärmebrücke dar, die den thermischen Pfad zu einem metallischen Kühlkörper aus Aluminium (Al) oder Kupfer (Cu) herstellt, der die Berandungsfläche der umhüllten Baugruppe verlässt oder ohne Bedeckung in der Ebene der Oberfläche angeordnet ist. Die Haftung der Masse wird besonders bevorzugt durch eine chemische Bindung (also eine stoffliche Verbindung mit besonders guter Wärmeleitung). So kann durch eine einerseits substratverbundene Kühlung und eine Umhüllungsmassen verbundene Kühlung für mehrseitige Abfuhr von Wärme gesorgt werden.

Das unbeschichtete Bauelement auf dem Substrat bzw. die unbeschichtete Baugruppe kann bevorzugt eine haftvermittelnde Schicht (Primer) aufweisen, insbesondere aus einer Poly-Acrylatdispersion. Diese Dispersion wird als dünne Schicht auf die Baugruppe aufgebracht (z.B. durch Sprühen) und bedeckt die zu umhüllenden Bauelemente und die bauteilseitige Fläche des Substrates, soweit sie von der Umhüllungsmasse bedeckt wird.

Da Zement typischerweise nach dem Abbinden eine Restporosität aufweist, kann ein feuchtebeständiger Überzug vorgesehen sein. Dazu sind zwei Strategien möglich: Entweder Verfüllen der Kapillaren durch niedrig-viskose Schutzmassen, die durch eine Aushärtung dauerhaft die Kapillaren abdichten - dazu sind insbesondere wässrige Lösungen von Kalium- oder Lithiumsilicaten geeignet. Oder Überziehen der Zementoberfläche mit einer Schutzschicht, die nicht oder nur gering von Feuchtigkeit penetriert wird - dazu geeignet sind insbesondere ausgehärtete Epoxydharzschichten (Lacke).

Die Dehnungsunterschiede von Halbleiterbauelementen, Substraten und Umhüllung sind zwar erfindungsgemäß durch Wahl von anorganischem Zement minimiert, aber nicht grundsätzlich vermieden. So entstehen durch Temperaturgradienten innerhalb des umhüllten Volumens auch mechanische Spannungen, die insbesondere an den Grenzflächen zu Halbleitern und zum Substrat zu Scherspannung innerhalb des Zementes führen. Zemente sind zwar relativ druckspannungsstabil, aber empfindlich gegenüber Zugspannungen.

Daher ist bevorzugt vorgesehen, Fasern in die Rohmasse des Zementes als Zuschlagstoff einzubringen, die die Zugspannung auf ein größeres Volumen verteilen und dadurch die Zugspanungsfestigkeit steigern. Dies führt zu insgesamt höherer Temperaturwechselfestigkeit. Geeignete Fasern müssen, ebenso wie der Zement, elektrisch nicht-leitend und stofflich mit dem Zement verbindungsfähig sein. Anorganische Fasern kommen hier zum Einsatz wie zum Beispiel Glasfasern, Basaltfasern, Borfasern und keramische Fasern, beispielsweise Siliziumkarbidfasern und Aluminiumoxidfasern. Es sind auch hochschmelzende, organische Fasern einsetzbar, wie zum Beispiel Aramidfasern.

Die stoffliche Fügemöglichkeit des Zementes ermöglicht eine bevorzugte Wärmeleitung vom verlustleistungsbehafteten Halbleiter über die Zementmasse zum Kühlkörper. Dies kann sowohl einseitig, wie auch - ausgehend vom Halbleiter - mehrseitig sein.

Die Erfindung wird anhand von in den Zeichnungen dargestellten besonders bevorzugt ausgebildeten Ausführungsbeispielen näher erläutert. Die Zeichnungen 2-5 zeigen Beispiele, die nicht unter den Schutzumfang der Ansprüche fallen, sondern das Verständnis der Erfindung erleichtern.

Es zeigen:
- Fig. 1: den schematischen Aufbau eines erfindungsgemäß ausgestalteten Halbleitermoduls gemäß einem ersten Ausführungsbeispiel, bei dem die Umhüllungsmasse als glob-top ausgebildet ist;
- Fig. 2: den schematischen Aufbau eines Halbleitermoduls nach einem Beispiel eines Moduls, das mit Ausnahme der mechanisch-elektrischen Kontaktzuführungen vollständig von der Umhüllungsmasse umhüllt ist;
- Fig. 3: den schematischen Aufbau eines Beispiels eines Halbleitermoduls mit beidseitig des Halbleiters angeordneten Kühlkörpern zur Luftkühlung;
- Fig. 4: den schematischen Aufbau eines Beispiels eines Halbleitermoduls mit beidseitig des Halbleiters angeordneten Kühlkörpern zur Wasserkühlung; und
- Fig. 5: den schematischen Aufbau eines Beispiels eines Halbleitermoduls mit einem auf der einen Seite des Halbleiters angeordneten Kühlkörper zur Luftkühlung und einem auf der anderen Seite des Halbleiters angeordneten Kühlkörper zur Wasserkühlung.

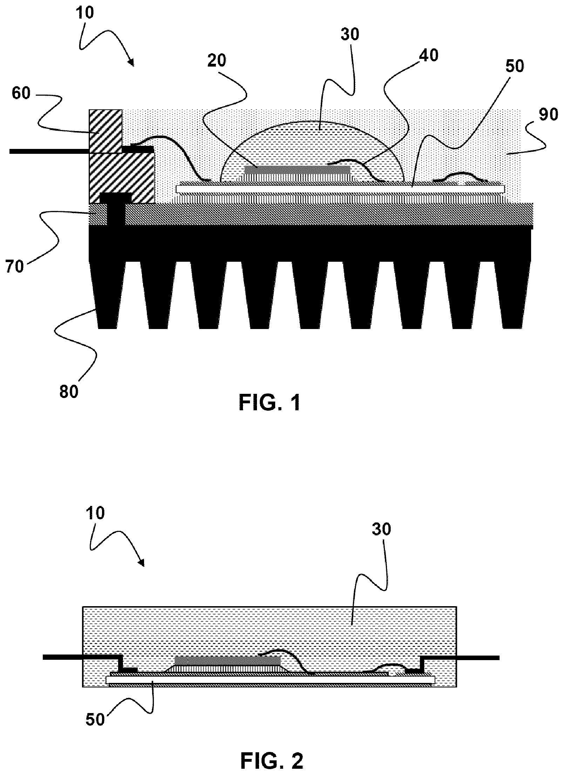

Fig. 1 zeigt den schematischen Aufbau eines erfindungsgemäß ausgestalteten Halbleitermoduls gemäß einem ersten Ausführungsbeispiel, bei dem die Umhüllungsmasse als Glob-top ausgebildet ist.

Fig. 1 zeigt ein bevorzugt als leistungselektronische Baugruppe ausgebildetes Halbleitermodul 10 mit einem Halbleiterbaustein 20, der mit einer erfindungsgemäß aus Zement bestehenden Umhüllungsmasse bedeckt ist. Bevorzugt sind auch die den Halbleiterbaustein 20 kontaktierenden Bonddrähte mit der Umhüllungsmasse zumindest teilweise, besonders bevorzugt aber vollständig bedeckt bzw. umhüllt.

Der Halbleiterbaustein ist dabei - wie bekannt - auf einem Keramiksubstrat 50 befestigt, das wiederum auf der Oberseite einer Wärmespreizplatte 70 aufgebracht ist, deren Unterseite mit einem Kühlkörper 80 verbunden ist. Darüber hinaus weist das Halbleitermodul 10 einen Rahmen 60 als Träger von nach Außen geführten elektrischen Kontakten auf.

Bei diesem ersten Ausführungsbeispiel ist die aus Zement bestehende Umhüllungsmasse 30 lediglich als den Halbleiterbaustein 20 und dessen Bonddrähte 40 bedeckender/umhüllender Tropfen ("*glob-top"*) ausgebildet. Der *"glob-top"* und die weiteren Oberflächenbereiche des Halbleitermoduls 10 sind dabei von einer Isolationsmasse 90, beispielsweise einem Silikongel, bedeckt.

Fig. 2 zeigt ein mit einem rahmenlosen Aufbau konstruiertes Halbleitermodul 10, das mit Ausnahme der elektrischen und thermischen Kontaktflächen vollständig mit der aus Zement bestehenden Umhüllungsmasse umhüllt ist.

Diese Ausgestaltung eignet sich insbesondere als Ausgangspunkt für die in den folgenden Figuren gezeigten Ausführungsbeispiele:

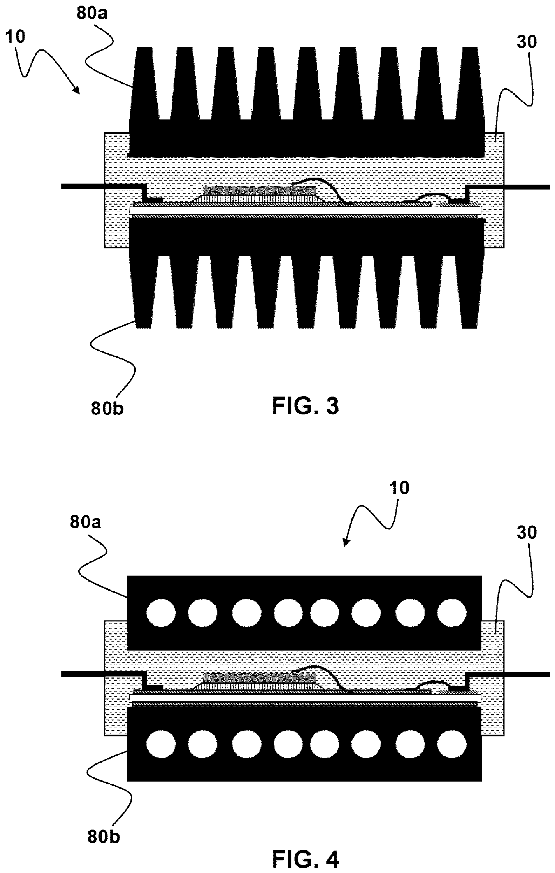

Fig. 3 zeigt eine Leistungsbaugruppe mit einer zweiseitig vorgesehenen Luftkühlung, wobei der obere Kühlkörper 80 a mit einer Wärmebrücke bestehend aus der anorganischen Umhüllungsmasse aus Zement, die stofflich den Kühlkörper kontaktiert, und der untere Kühlkörper 80b durch stoffliche Verbindung zum Substrat verbunden ist.

Die dargestellte Kühlerstruktur ist jeweils einstückig und mit Kühlrippen oder Kühlstiften versehen, damit ein Luft- oder Wasserdurchtritt möglichst turbulent erfolgt.

Fig. 4 zeigt eine Leistungsbaugruppe mit zweiseitiger Wasserkühlung entsprechend der in Fig. 3 gezeigten Ausgestaltung, wobei die in Fig. 4 dargestellte Kühlerstruktur einstückig ausgebildet und mit inneren Wasserführungskanälen versehen, damit ein Wasserdurchtritt möglichst in einer geschlossenen Struktur mit geringer Dichtungslänge erfolgen kann.

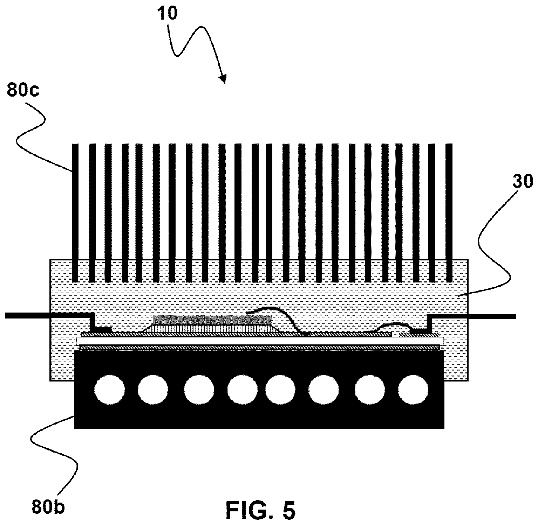

Fig. 5 schließlich zeigt eine Leistungsbaugruppe mit zweiseitiger Kühlung, wobei der untere Kühlkörper 80b erneut einstückig, der obere Kühlkörper 80c aber mehrteilig ausgebildet ist. Die als oberer Kühlkörper 80c dargestellte Kühlerstruktur besteht beispielsweise aus einer Mehrzahl von sich über die Oberseite des Halbleitermoduls 10 erstreckende Kühlplatten oder einer Mehrzahl von sich über der Oberfläche des Halbleitermoduls 10 verteilenden Kühlstiften.

Der Vorteil der Verwendung von Zement als Umhüllungsmasse bzw. Matrix für die Umhüllung von Halbleiterbausteinen oder Halbleiterbaugruppen, insbesondere leistungselektronischen Baugruppen, liegt in einer guten Wärmeleitfähigkeit von 1,2 bis 1,6W/mK und einer geringen thermischen Dehnung (CTE) von etwa 4,7 ppm/K. Zudem ist Zement halogenfrei und metallverträglich. Da das Umhüllen des Halbleiterbausteins bzw. der Halbleiterbaugruppe unter atmosphärischen Bedingungen und in Temperaturbereichen erfolgen kann, die der Betriebstemperatur des Halbleitermoduls entsprechen, kann sich das Halbleitermodul nicht verziehen. Schließlich ist auch eine Haftung von Zement auf Leiterplattenoberflächen (Cu, Ni/Au) gegeben.

## Patentansprüche

1. Als leistungselektronische Baugruppe ausgebildetes Halbleitermodul (10) mit einer einen auf einem Keramiksubstrat (50) befestigten Halbleiterbaustein (20) bedeckenden als glob-top ausgebildeten Umhüllungsmasse (30), wobei das Keramiksubstrat (50) auf der Oberseite einer Wärmespreizplatte (70) aufgebracht ist, deren Unterseite mit einem Kühlkörper (80) verbunden ist, wobei das Halbleitermodul (10) einen Rahmen (60) als Träger von nach Außen geführten elektrischen Kontakten aufweist, wobei die Umhüllungsmasse (30) aus den Basisrohstoffen Magnesiumoxid, Zirkonsilikat und Magnesiumphosphat hergestellter Zement ist, wobei die den Halbleiterbaustein (20) kontaktierenden Bonddrähte mit der Umhüllungsmasse zumindest teilweise umhüllt sind und wobei der "glob-top" und die weiteren Oberflächenbereiche des Halbleitermoduls (10) von einer Isolationsmasse (90) bedeckt sind.

2. Als leistungselektronische Baugruppe ausgebildetes Halbleitermodul (10) gemäß Anspruch 1, wobei die Isolationsmasse (90) ein Silikongel ist.

## Claims

1. Semiconductor module (10), provided as power electronic assembly, with an encapsulating mass (30) that is provided as glob-top and covers a semiconductor component (20) that is attached to a ceramic substrate (50), whereby the ceramic substrate (50) is applied to the top side of a heat dissipation plate (70) the underside of which is connected to a cooling body (80), whereby the semiconductor module (10) comprises a frame (60) as support of electrical contacts that are guided outwards, whereby the encapsulating mass (30) is a cement produced from magnesium oxide, zirconium silicate, and magnesium phosphate as the basic raw materials, whereby the bond wires contacting the semiconductor component (20) are encapsulated, at least in part, by the encapsulating mass, and whereby the "glob-top" and the further surface regions of the semiconductor module (10) are covered by an insulating mass (90).

2. Semiconductor module (10), provided as power electronic assembly, according to claim 1, whereby the insulation mass (90) is a silicon gel.

## Revendications

1. Module semi-conducteur (10) réalisé en tant que bloc d'électronique de puissance avec une masse d'enrobage (30) réalisée en tant que glob-top recouvrant un élément semi-conducteur (20) fixé sur un substrat en céramique (50), dans lequel le substrat en céramique (50) est appliqué sur le côté supérieur d'une languette écartable thermique (70) dont le côté inférieur est connecté à un dissipateur thermique (80), dans lequel le module semi-conducteur (10) présente un cadre (60) en tant que support de contacts électriques guidés vers l'extérieur, dans lequel la masse d'enrobage (30) est du ciment fabriqué à partir des matières brutes de base oxyde de magnésium, silicate de zirconium et phosphate de magnésium, dans lequel les fils de connexion venant en contact avec l'élément semi-conducteur (20) sont au moins partiellement enrobés de la masse d'enrobage et dans lequel le « glob-top » et les autres régions superficielles du module semi-conducteur (10) sont recouverts d'une masse d'isolation (90).

2. Module semi-conducteur (10) réalisé en tant que bloc d'électronique de puissance selon la revendication 1, dans lequel la masse d'isolation (90) est un gel de silicone.
